# EUROPEAN PATENT APPLICATION

(11) **EP 0 948 035 A1**
(43) Date of publication of application: **06.10.1999**
(21) Application number: 98104983.6
(22) Date of filing: 19.03.1998
(51) Int. Cl.: H01L 21/3105, H01L 21/768

(54) **Method for applying a dielectric cap film to a dielectric stack**

(71) Applicant: APPLIED MATERIALS, INC., Santa Clara, California 95050 (US)
(72) Inventor: van der Reijden, Marc J., 5361 JB Grave (NL)
(74) Representative: Kirschner, Klaus Dieter, Dipl.-Phys.

(57) **Abstract**

There is provided a method for applying a dielectric cap film (24) to a dielectric stack, which is provided on top of metal structures (6) of a semimanufactured chip during production of an IC-device and which comprises a SOG (Spin On Glass) film (12) as top layer, wherein the cap film (24) is produced by a SACVD (Subatmospheric Chemical Vapor Deposition) gap-filling process whereby full planarization of the IMD (Inter Metal Dielectric) stack is achieved as a global as well as a local planarization.

## Description

The invention relates to a method for applying a dielectric cap film to a dielectric stack.

During the production of IC-devices within appropriate processing chambers, there is a stage where metal topography structures that have been deposited on a substrate is to be covered by an insulating dielectric film in order to be able to apply another metal topography structure perpendicular to the already existing metal structure on top of the insulating dielectric stack. The dielectric stack is conventionally produced by depositing a first dielectric film on the metal structure, depositing a second dielectric film on the first dielectric film, etching the second dielectric film back to a level where at the location in the first dielectric film where vias are to be etched, is reached, and then a cap film is produced on top of the etched structure.

During such a production process, problems are encountered when the second dielectric film is a SOG film and the cap film is produced as a PTEOS film. In case the first dielectric film is a PTEOS film, the top surface of this film will follow the topography of the metal structure. The SOG film which is produced on top of the PTEOS film will level out some of the topography, but the spun SOG film is usually very thin on a pair of two isolated lines in the chip.

On the bondpads in the center of their metal structure, the SOG film has the nominal thickness. During etching of the SOG film, the bondpads must be cleared totally of SOG to prevent poisoning of vias which are to be etched later on through to the metal structure. This clearing of the bondpads requires a certain minimal etch time. As the SOG film on the isolated paired metal structures (lines) is very thin, the SOG film will be removed from the top of the lines before the minimal etching time is reached, and during the rest of the etching time some of the SOG film between the two metal lines will be removed. Thus, a SOG pocket will be formed.

In the next process step of this conventional method, the wafer is covered by a PTEOS film to cap the portions of the SOG film which are left over from etching. The cap film is supposed to be flat. However, if the SOG pocket between the two paired metal lines is too deep, a micro-trench or a microscopic groove is formed in the cap film at the location of the former SOG pocket. This trench becomes a problem when the metal interconnect structure is produced on top of and through the cap film by deposition and back-etching. Assuming that the metal topography structure is to be etched from a tungsten film, the etching step is not capable of removing the metal in the deepest part of the micro-trench or groove. If one achieves the complete removal by etching, over etching can occur on tungsten part elsewhere on the chip, and in particular plugs of tungsten could be damaged.

The left over metal in the groove forms a short circuit in respect to the metal lines in the upper metal topography structure as the grooves which are filled with metal, are perpendicular to the metal topography structures. The micro-trenches or grooves formed in this way are deeper the deeper the SOG pockets are, because the planarization of the cap layer on the upper surface will be worse the deeper the SOG pockets are.

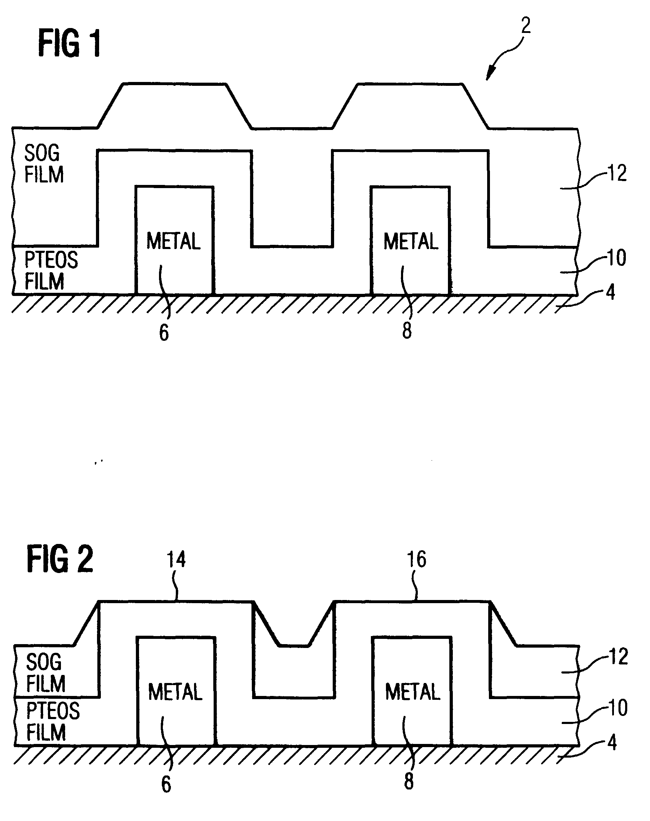

The above problems and the respective production stages are shown in more detail in the Figures 1 to 4 and described in connection therewith below.

The invention has been made in consideration of the above stated problem and has as an object to provide a simple and effective method for avoiding the formation of micro-trenches or grooves when producing the dielectric stack.

To achieve this object, there is provided a method for applying a dielectric cap film to a dielectric stack, which is provided on top of metal structures of a semimanufactured chip during production of an IC-device and which comprises a SOG (Spin On Glass) film as top layer, wherein the cap film is produced by a SACVD (Subatmospheric Chemical Vapor Deposition) gap-filling process whereby full planarization of the IMD (Inter Metal Dielectric) stack is achieved as a global as well as a local planarization. This method solves the above problem because a gap-filling material is used to cover the SOG film. The gap-filling material will guarantee a high level of planarization in spite of deep SOG pockets caused by extensive SOG etch-back. The micro-trenches or grooves will no longer be formed so that the above problem does not arise anymore. As the planarization is achieved as a global as well as a local planarization, neither large scale planarization steps nor microscale planarization steps are necessary.

A further advantage is the fact that CVD deposition chambers which can be used to produce SACVD films can also be used to deposit PTEOS films so that no additional apparatus for the fabrication of the chips is necessary.

According to a preferred embodiment of the invention, there is provided a method wherein the SACVD gap-filling process is a TEOS-based (based on tetraethylorthosilicate) SACVD process. Such a film is advantageous since TEOS-based films are preferred as films covering a SOG film as concerns handling, etching conditions and dielectric properties of the dielectric stack.

According to another preferred embodiment of the invention, there is provided a method wherein the dielectric stack is produced by:
- depositing a first dielectric film on the metal structure,
- depositing a second dielectric film which is a SOG film, on the first dielectric film,
- etching the second dielectric film back to a level where the PTEOS, at the location in the first dielectric film where vias are to be etched the first dielectric film is reached, i.e. where the PTEOS in the first dielectric film on top of the metal structures is reached, and
- wherein the cap film is produced by depositing a third dielectric film which is a SACVD film, on top of the second dielectric film. This sequence is particularly advantageous to form the desired dielectric stack and to have a planar surface for building up the next metal structure on top of the cap layer.

According to another preferred embodiment of the invention, there is provided a method wherein the first dielectric film is deposited as a PTEOS (Plasma enhenced TEOS) film and wherein depositing the SACVD film involves depositing a TEOS-based SACVD film. Using PTEOS as the first dielectric layer and using TEOS also as a starting material for the deposition of the SACVD film is advantageous that a vacuum deposition chamber with the same basic structure can be used for depositing both films which reduces the bulk and also the costs for the apparatus to produces the respective films.

According to another preferred embodiment of the invention, there is provided a method wherein the etching of the second dielectric film is continued until the first dielectric film is partly etched down, whereafter the third dielectric film is deposited. This additional etching down of the second dielectric film which is advantageous in view of the overall effect of the deposition process for the dielectric stack, can be done without worrying about the depth of the SOG pocket produced as the subsequent deposition of the cap film equals out any topography which might be left or created by such additional etch down.

According to another preferred embodiment of the invention, there is provided a method wherein the cap film is produced by depositing a forth dielectric film which is a PTEOS film, on top of the third dielectric film. For some applications, it might be advantageous to have a PTEOS film as a top film of the dielectric step and as a basis for the deposition of the next metallic topography structure.

The state of the art and preferred embodiments of the invention will now be described in detail in conjunction with the accompanying drawings in which:
Fig. 1 is a schematic cross section of a semimanufactured chip of the state of the art which cross section is not in scale and shows metal lines covered by a PTEOS film which again is covered by a SOG film;
Fig. 2 is a schematic cross section of a semimanufactured chip of the state of the art which is not in scale and shows metal lines which are covered by a PTEOS film which again is covered by a SOG film which is etched down until the SOG is completely removed on top of the upper surfaces of the PTEOS film;
Fig. 3 is a schematic cross section of a semimanufactured chip of the state of the art which is not in scale and shows metal lines which are covered by PTEOS film and SOG on top of the upper surfaces of the PTEOS film as well as part of the PTEOS film being etched down;
Fig. 4 is a schematic cross section of a semimanufactured chip of the state of the art which is not in scale and has metal lines which are covered by PTEOS film which again is covered by a PTEOS cap film;
Fig. 5 is a schematic cross section of a semimanufactured chip of the invention which has metal lines which are covered by PTEOS film and in which the SOG film is covered by a TEOS-based SACVD gap-filling film.

It is to be noted that the production stages shown in the Figures 1 to 4 and described in connection therewith are conventional state of the art in this technology.

The semimanufactured chip 2 which is shown in Fig. 1, comprises a substrate 4, metal lines 6, 8 which are part of a metal topography structure, a PTEOS film 10 which covers the metal lines 6, 8, and a SOG film 12 which again covers the PTEOS film 10. In this semimanufactured chip, this structure is the starting point for producing a semimanufactured chip on which the next metal structure is to be deposited. The IMD consists of the PTEOS film which serves as a seed/bottom layer over the metal topography structures represented by the metal lines 6, 8, on which the SOG film 12 is deposited which can be etched with a controlled selectivity to PTEOS.

As can be seen from Fig. 1, the SOG film 12 still has some topography but far less topography than the original metal lines 6, 8 on the substrate 4 and the PTEOS film 10 which covers the substrate 4 and the metal lines 6, 8. The deposition of the SOG film 12 is, therefore, a first step to have a planar upper surface of the semimanufactured chip.

In a next step which is shown in Fig. 2, the SOG film 12 is etched down at least until the PTEOS film 10 is reached above the metal lines 6, 8 or at the upper surfaces 14, 16 where, in a later processing step, vias fill be etched down to the metal lines 6, 8.

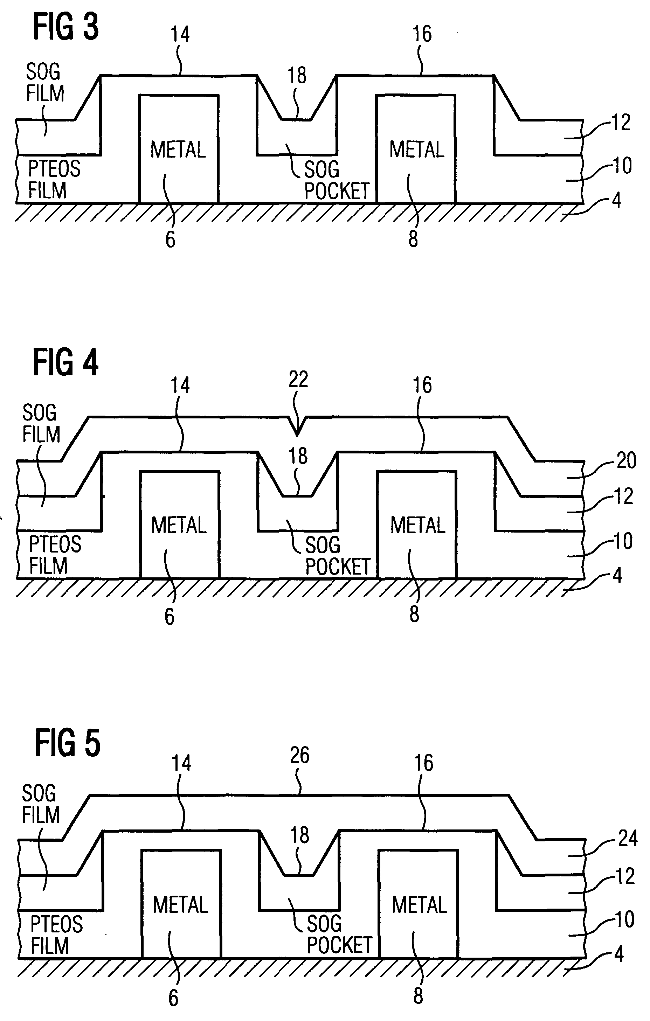

When, during the etching process, the SOG film 12 is removed from the highest structures of the PTEOS film 10, the PTEOS film 10 will be attacked. As the PTEOS film 10 is etched down faster than the SOG film 12, such additional etching should even out the remaining topography some more. However, due to loading and selectivity characteristics, sometimes, some significant topography is still left over as can be seen in Fig. 3. A comparatively deep SOG pocket 18 (Fig. 3) is formed in the area generally in between the metal lines 6, 8. This SOG pocket 18 is not necessarily a problem for the lithographic steps to be carried out but causes a problem when the next metal structure is to be made by depositing a metal layer and etching this metal layer.

After the SOG film has been etched back, which stage is shown in Fig. 3, conventionally a PTEOS film 20 is deposited on top of the surface of the SOG film 12 and the upper surfaces 14, 16 of the PTEOS film 10 to cover these surfaces and separate the SOG film 12 from the next metal film (not shown) that is to be deposited. This second PTEOS film 20, i.e. the cap film, follows the surface profile or topography thereby creating micro-trenches 22 in areas where some topography was left, i.e. at the SOG pocket 18, as the portions of the second PTEOS film 20 grow towards each other on the slopes of the SOG pocket 18. This stage of the manufacturing process is shown in Fig. 4.

It is to be noted that the production stages described up to now are conventional in this technology. The invention is directed to solve the problem created by the SOG pocket when covered by the second PTEOS film 20, i.e. with the problem of the micro-trench 22.

In the next process stage after the stage shown in Fig. 4, tungsten-plug technology is typically used, and vias (not shown) are etched, and after this process step, metal alloys and films are deposited on top of the semimanufactured chip shown in Fig. 4. These metal films are only meant for adhesion, anti-reflection and electrical conduction in the hole. The films are etched back from the planar surface later on. However, problems occur when small grooves like the micro-trench 22 exist in the dielectric film because the metal films should be removed completely but sometimes some metal is left behind (not shown) in the micro-trenches like the micro-trench 22 creating a very thin metal line.

The metal lines of the next level (not shown) will be perpenticular to the previous metal lines 6, 8, while the metal lines formed in the micro-trenches 22 have the same direction as the metal lines 6, 8 in the bottom. The micro-trenches 22 are, therefore, perpendicular to the metal lines (not shown) of the upper metal topography structure. Therefore, if metal residues are left behind in the micro-trenches 22, such metal forms a short circuit for the next metal topography structure in the next level.

Fig. 5 is a schematic cross section of a semimanufactured chip of the invention which has metal lines which are covered by PTEOS film and in which the SOG film is covered by a TEOS-based SACVD gap-filling film. It is to be noted that this production stage shows the invention.

Fig. 5 shows a semimanufactured chip in which the cap film 24 is a TEOS-based SACVD film 24, i.e. a film produced by means of a gap-filling process, which film 24 has a planar top surface 26 which does not show micro-trenches in spite of the fact that SOG pockets 18 are present also before the deposition of the cap film 24. Obviously, such a planar surface 26 of the cap layer 24 does not produce the problems discussed above. In other words, the invention is based on a dielectric stack which is produced by a combination of etching back a SOG film with the production of a gap-filling film on top of the etched back SOG film. In particular IMD planarization with a gap-filling technology is used on top on or in combination with an etched back SOG film.

In the invention, a combination of SOG capping and gap/micro-trench filling is carried out at the same time using one and the same material. At the same time, the advantages of using a SOG film are kept.

## Claims

1. A method for applying a dielectric cap film to a dielectric stack, which is provided on top of metal structures of a semimanufactured chip during production of an IC-device and which comprises a SOG film as top layer, wherein the cap film is produced by a SACVD gap-filling process whereby full planarization of the IMD stack is achieved as a global as well as a local planarization.

2. A method according to claim 1, wherein the SACVD gap-filling process is a TEOS-based SACVD process.

3. A method according to claim 1, wherein the dielectric stack is produced by:
- depositing a first dielectric film, preferably a PTEOS film, on the metal structure,
- depositing a second dielectric film which is a SOG film, on the first dielectric film,
- etching the second dielectric film back to a level where the PTEOS, at the location in the first dielectric film where vias are to be etched is reached, i.e. where the PTEOS in the first dielectric film on top of the metal structures is reached, and
- wherein the cap film is produced by depositing a third dielectric film which is a TEOS-based SACVD film, on top of the second dielectric film.

4. A method according to claim 1, wherein the dielectric stack is produced by:
- depositing a first dielectric film, preferably a PTEOS film, on the metal structure,
- depositing a second dielectric film which is a SOG film, on the first dielectric film,
- etching the second dielectric film back to a level where the location in the first dielectric film where vias are to be etched, is reached, i.e. where the location in the first dielectric film on top of the metal structures is reached, and
- wherein the cap film is produced by depositing a third dielectric film which is a TEOS-based SACVD film, on top of the second dielectric film and by depositing a forth dielectric film which is a PTEOS film, on top of the third dielectric film.

5. A method according to claim 3 or 4, wherein depositing the SACVD film involves depositing a TEOS-based SACVD film.

6. A method according to claim 3, 4 or 5, wherein the etching of the second dielectric film is continued until the first dielectric film is partly etched down, whereafter the third dielectric film is deposited.
